# EUROPÄISCHE PATENTSCHRIFT

(11) **EP 4 217 526 B1**
(45) Veröffentlichungstag und Bekanntmachung des Hinweises auf die Patenterteilung: **13.11.2024**
(21) Anmeldenummer: 21794710.0
(22) Anmeldetag: 23.09.2021
(51) Int. Cl.: C30B 23/00, C30B 29/36

(54) **VERFAHREN ZUR SILIZIUMCARBIDEINKRISTALL-HERSTELLUNG**
METHOD FOR PRODUCING SILICON CARBIDE SINGLE CRYSTALS
PROCÉDÉ DE PRODUCTION DE MONOCRISTAUX DE CARBURE DE SILICIUM

(30) Priorität: 28.09.2020 AT 508192020
(43) Veröffentlichungstag der Anmeldung: 02.08.2023
(73) Patentinhaber: EBNER Industrieofenbau GmbH, 4060 Leonding (AT)
(72) Erfinder: ARIYAWONG, Kanaparin, 4060 Leonding (AT); BARBAR, Ghassan, 57290 Neunkirchen (DE); EBNER, Robert, 4060 Leonding (AT); HSIUNG, Chih-Yung, 4060 Leonding (AT)
(74) Vertreter: Burger, Hannes
(86) Internationale Anmeldenummer: PCT/AT2021/060341
(87) Internationale Veröffentlichungsnummer: WO 2022/061386

(56) Entgegenhaltungen:
- WO-A1-2020/087723
- JP-A- 2018 118 874
- KR-A- 20130 013 709
- US-B2- 9 816 200

## Beschreibung

Die Erfindung betrifft ein Verfahren zur Herstellung von Einkristallen aus Siliziumcarbid.

Für viele technische Anwendungen werden heute Einkristalle in industriellem Maßstab künstlich hergestellt. Nach den Phasenübergängen, die zu dem Kristall führen, können dabei die Züchtung aus der Schmelze, aus der Lösung und aus der Gasphase unterschieden werden. Bei der Züchtung aus der Gasphase können weiters die Herstellungsmethoden der Sublimation bzw. der physikalischen Gasphasenabscheidung sowie die Methode der chemischen Gasphasenabscheidung unterschieden werden. Bei der physikalischen Gasphasenabscheidung wird die zu züchtende Substanz durch Erhitzen verdampft, sodass sie in die Gasphase übergeht.

Das Gas kann unter geeigneten Bedingungen an einem Keimkristall resublimieren, wodurch ein Wachstum des Kristalls erfolgt. Das üblicherweise polykristallin vorliegende Rohmaterial (Pulver oder Granulat) erfährt auf diese Weise eine Umkristallisation. Ähnlich funktioniert die chemische Gasphasenabscheidung. Bei dieser wird der Übergang der zu züchtenden Substanz in die Gasphase erst durch eine Hilfssubstanz, an die die Substanz chemisch bindet, möglich, da sonst der Dampfdruck zu gering wäre. In Verbindung mit der Hilfssubstanz wird so eine höhere Transportrate hin zu dem Keimkristall erreicht.

An Siliziumcarbid-Einkristallen besteht insbesondere wegen ihrer Halbleiter-Eigenschaften großes Interesse. Ihre Herstellung wird in Öfen mit einem Tiegel, in dem das Siliziumcarbid-Rohmaterial aufgeheizt wird, und einem Keimkristall, an dem durch Anlagerung das weitere Kristallwachstum erfolgt, durchgeführt. Das Innere der Prozesskammer ist außerdem evakuiert. Als Material für die innerste Prozesskammer mit dem Tiegel wird Graphit verwendet.

Von großer Wichtigkeit für die Qualität des Siliziumcarbid-Einkristalls ist die Beschaffenheit des Siliziumcarbid-Rohmaterials.

US 9816200 B2 und JP 2018118874 A offenbaren jeweils ein Verfahren zur Herstellung von Einkristallen aus Siliziumcarbid, wobei als Ausgangsmaterial eine Mischung aus kleineren und größeren Siliziumcarbidteilchen verwendet wird.

Die Aufgabe der vorliegenden Erfindung war es, die Nachteile des Standes der Technik zu überwinden und ein Verfahren zur Verfügung zu stellen, mittels dessen eine Herstellung von Einkristallen mit höherer Qualität möglich wird.

Diese Aufgabe wird durch ein Verfahren gemäß den Ansprüchen gelöst.

Die Vorrichtung zur Herstellung von Einkristallen aus Siliziumcarbid ist ausgebildet mit einem Ofen und einer in dem Ofen aufgenommenen Kammer mit einem Tiegel und einem Keimkristall, wobei ein Siliziumcarbid enthaltendes Ausgangsmaterial in dem Tiegel angeordnet ist, und wobei das Ausgangsmaterial eine Mischung aus Siliziumcarbidpulver und Siliziumcarbidklumpen enthält.

Vorteilhaft ist dabei, wenn die Siliziumcarbidklumpen eine Korngröße mit einem Wert aus einem Bereich von 1 mm bis 10 mm aufweisen und wenn das Siliziumcarbidpulver eine Korngröße mit einem Wert aus einem Bereich von 150 µm bis 1000 µm aufweist.

Gemäß einer vorteilhaften Weiterbildung der Vorrichtung ist vorgesehen, dass bezogen auf eine Gesamtmasse das Ausgangsmaterial Siliziumcarbidpulver und Siliziumcarbidklumpen in einem Mischungsverhältnis enthält, das ausgewählt ist aus einem Bereich von 25 % Gewichtsanteil Siliziumcarbidpulver zu 75 % Gewichtsanteil Siliziumcarbidklumpen bis 55 % Gewichtsanteil Siliziumcarbidpulver zu 45 % Gewichtsanteil Siliziumcarbidklumpen. Besonders vorteilhaft ist, wenn bezogen auf die Gesamtmasse das Ausgangsmaterial Siliziumcarbidpulver und Siliziumcarbidklumpen in einem Mischungsverhältnis von 40 % Gewichtsanteil Siliziumcarbidpulver zu 60 % Gewichtsanteil Siliziumcarbidklumpen enthält. Vorteilhaft ist auch, dass das Siliziumcarbid des Ausgangsmaterials eine Stoffreinheit von größer 5N aufweist.

Gemäß einer bevorzugten Ausführungsform ist vorgesehen, dass das Ausgangsmaterial in unterschiedlichen Bereichen einer Höhe des Ausgangsmaterials unterschiedliche Mischungsverhältnisse von Siliziumcarbidpulver und Siliziumcarbidklumpen aufweist.

Dabei erweist es sich insbesondere als vorteilhaft, wenn in einem ersten, unteren Drittel der Höhe des Ausgangsmaterials Siliziumcarbidpulver und Siliziumcarbidklumpen in einem Mischungsverhältnis enthalten sind, das ausgewählt ist aus einem Bereich von 55 % Siliziumcarbidpulver zu 45 % Siliziumcarbidklumpen bis 70 % Siliziumcarbidpulver zu 30 % Siliziumcarbidklumpen.

Und weiters, wenn in einem zweiten, mittleren Drittel der Höhe des Ausgangsmaterials Siliziumcarbidpulver und Siliziumcarbidklumpen in einem Mischungsverhältnis enthalten sind, das ausgewählt ist aus einem Bereich von 40 % Siliziumcarbidpulver zu 60 % Siliziumcarbidklumpen bis 55 % Siliziumcarbidpulver zu 45 % Siliziumcarbidklumpen.

Von Vorteil ist auch, wenn in einem dritten, oberen Drittel der Höhe des Ausgangsmaterials Siliziumcarbidpulver und Siliziumcarbidklumpen in einem Mischungsverhältnis enthalten sind, das ausgewählt ist aus einem Bereich von 25 % Siliziumcarbidpulver zu 75 % Siliziumcarbidklumpen bis 40 % Siliziumcarbidpulver zu 60 % Siliziumcarbidklumpen.

Gemäß einer alternativen Weiterbildung ist vorgesehen, dass das Ausgangsmaterial in der Form eines Presslings gefertigt ist.

Von Vorteil ist auch eine Ausbildung, bei der das Ausgangsmaterial zusätzlich zum Siliziumcarbid elementares Silizium enthält, insbesondere, wenn das elementare Silizium in Form von Siliziumpulver enthalten ist.

Eine vorteilhafte Weiterbildung sieht vor, dass das elementare Silizium in Form eines oder mehrerer Lager in dem Ausgangsmaterial eingeformt ist.

Besonders bevorzugt ist das Lager mit dem elementaren Silizium zu einem zusammenhängenden Ring geformt.

Vorteilhaft ist insbesondere, wenn das elementare Silizium einen Anteil aus einem Bereich von 5 % Gewicht bis 50 % Gewicht einer Gesamtmasse des Ausgangsmaterials bildet.

Eine alternative Ausbildung der Vorrichtung sieht vor, dass ein Vorratsbehälter für das pulverförmige, elementare Silizium und eine in den Tiegel führende Zuleitung ausgebildet sind.

Von Vorteil ist auch, wenn der Tiegel aus Graphit hergestellt ist.

Zum besseren Verständnis der Erfindung wird diese anhand der nachfolgenden Figuren näher erläutert.

Es zeigen jeweils in stark vereinfachter, schematischer Darstellung:
- Fig. 1: eine Vorrichtung zur Herstellung von Einkristallen mittels physikalischer Gasphasenabscheidung;
- Fig. 2: ein Detail des Tiegels der Vorrichtung gemäß Fig. 1;
- Fig. 3: ein zweites Ausführungsbeispiel der Vorrichtung zur Einkristall-Herstellung mit einem zu einem Pressling geformten Ausgangsmaterial;
- Fig. 4: ein drittes Ausführungsbeispiel der Vorrichtung zur Einkristall-Herstellung;
- Fig. 5: ein viertes Ausführungsbeispiel der Vorrichtung zur Einkristall-Herstellung;
- Fig. 6: ein fünftes Ausführungsbeispiel der Vorrichtung zur Einkristall-Herstellung.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

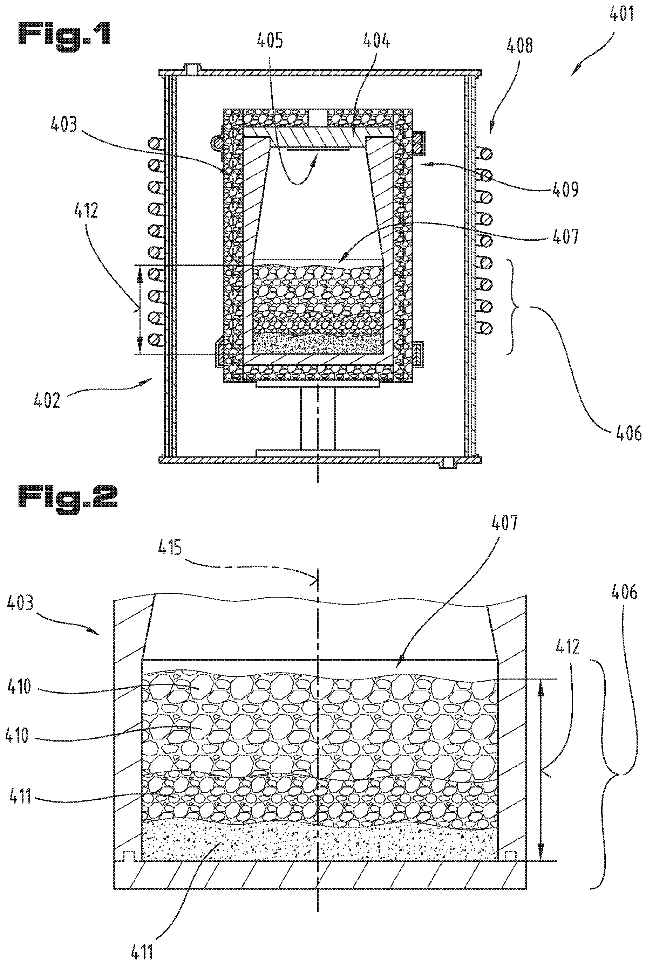

Die Fig. 1 zeigt einen Ofen 401 zur Herstellung von Einkristallen mittels physikalischer Gasphasenabscheidung. Der Ofen 401 umfasst eine evakuierbare Kammer 402 mit einem darin aufgenommenen Tiegel 403. Der Tiegel 403 ist im Wesentlichen topfförmig ausgebildet, wobei ein oberer Endbereich durch einen Deckel 404 abgeschlossen wird. Eine Unterseite des Deckels 404 des Tiegels 403 ist dabei zur Befestigung eines Keimkristalls 405 ausgebildet. In einem Bodenbereich 406 des Tiegels 403 befindet sich ein Ausgangsmaterial 407 das als Rohstoff für das Kristallwachstum an dem Keimkristall 405 dient und das während des Herstellungsprozesses allmählich aufgebraucht wird.

Der Übergang des Ausgangsmaterials 407 in die Gasphase wird durch Erhitzen mithilfe einer Heizung 408 erreicht. Gemäß diesem Ausführungsbeispiel erfolgt das Aufheizen des Ausgangsmaterials 407 und des Tiegels 403 durch die Heizung 408 induktiv. Der in der Kammer 402 angeordnete Tiegel 403 ist außerdem zur thermischen Dämmung von einer Isolierung 409 umhüllt. Durch die Isolierung 409 werden gleichzeitig Wärmeverluste aus dem Tiegel 403 vermieden und wird eine für den Wachstumsprozess des Kristalls an dem Keimkristall 405 günstige Wärmeverteilung in dem Inneren des Tiegels 403 erreicht.

Als Material für die Kammer 402 dient vorzugsweise ein Glaswerkstoff, insbesondere ein Quarzglas. Der Tiegel 403 als auch die diesen umgebende Isolierung 409 bestehen vorzugsweise aus Graphit, wobei die Isolierung 409 durch einen Graphit-Filz gebildet wird.

Indem durch Erhitzen des Ausgangsmaterials 407 Atome bzw. Moleküle davon in die Gasphase übergehen, können diese in dem Innenraum des Tiegels 403 zu dem Keimkristall 405 diffundieren und sich daran ablagern, wodurch das Kristallwachstum erfolgt. Dabei wird die Ausbildung eines möglichst störstellenfreien Einkristalls angestrebt. Die Qualität des sich ausbildenden Kristalls an dem Keimkristall 405 hängt neben dem Temperaturgradienten zwischen dem Ausgangsmaterial 407 und dem Keimkristall 405 auch von der Verdampfungsrate von Ausgangsmaterial 407 ab. Letzteres ist wiederum davon abhängig, in welcher Form der Rohstoff des Ausgangsmaterials 407 in dem Tiegel 403 zur Verfügung gestellt wird. Als vorteilhaft erweist sich dabei, wenn das Ausgangsmaterial 407 durch eine Mischung aus einem pulverförmigen Rohstoff und einem in Form von Klumpen vorliegenden Rohstoff gebildet wird.

Die Fig. 2 zeigt ein Detail des Tiegels 403 des Ofens 401 gemäß Fig. 1. Bei diesem Ausführungsbeispiel ist als Rohstoff für das Ausgangsmaterial 407 Siliciumcarbid vorgesehen. Das Siliciumcarbid des Ausgangsmaterials 407 umfasst dabei Klumpen 410 als auch Pulver 411. Die Klumpen 410 und das Pulver 411 des Siliciumcarbids sind dabei in dem Bodenabschnitt 406 des Tiegels 403 lose aufgeschichtet. Wie in der Darstellung gemäß der Fig. 2 angedeutet, liegen das Pulver 411 und die Klumpen 410 dabei in gemischter Form vor. Als vorteilhaft erweist es sich dabei, wenn das Ausgangsmaterial 407 in unterschiedlichen Höhenbereichen des Bodenabschnitts 406 in unterschiedlichen Mischungsverhältnissen von Klumpen 410 und Pulver 411 vorliegt.

Die Dauer eines Fertigungsprozesses eines Einkristalls aus Siliciumcarbid in dem Ofen 401 erstreckt sich üblicherweise über mehrere Tage. Dabei hängt der Verbrauch des Rohstoffs des Ausgangsmaterials 407 auch ab von der durch die Heizung 408 in dem Ausgangsmaterial 407 erzeugten Temperaturverteilung, wobei sich über die Fortdauer des Prozesses die Verdampfungsrate des Rohstoffs entsprechend verändern kann. Dies, weil es zu einer allmählichen Verdichtung durch oberflächliches Verschmelzen der Teilchen des zu Beginn lose verteilten Rohstoffs des Ausgangsmaterials 407 kommt. Ein unterschiedliches Mischungsverhältnis von Siliciumcarbidklumpen 410 und Siliziumcarbidpulver 411 in den unterschiedlichen Füllbereichen bzw. in den unterschiedlichen Höhenbereichen des damit befüllten Bodenabschnitts 406 kann über die entsprechend lange Dauer des gesamten Kristallisationsprozesses zu einer möglichst gleichbleibenden Verdampfungsrate des Rohstoffs beitragen. Das Mischungsverhältnis von Klumpen 410 und Pulver 411 ist insofern von Bedeutung, da Pulver 411 des Rohstoffs gleichbedeutend ist mit einer großen Oberfläche und somit mit einer großen Verdampfungsrate und andererseits Klumpen 410 mit einer insgesamt geringeren Oberfläche eine kleinere Verdampfungsrate ergeben.

Bei dem Ausführungsbeispiel gemäß der Fig. 2 sind Klumpen 410 und Pulver 411 über eine Höhe 412 mit unterschiedlichen Mischungsverhältnissen aufgeschichtet. Dabei ist in einem ersten, unteren Drittel der Höhe 412 des Ausgangsmaterial 407 das Siliziumcarbidpulver 411 mit einem Anteil von 55 % bis 70 % des Gewichts enthalten. Entsprechend komplementär dazu ist in dem unteren Drittel der Höhe 412 ein Anteil von Siliziumcarbidklumpen 410 mit 30 % bis 45 % enthalten. In einem zweiten, mittleren Drittel der Höhe 412 des Ausgangsmaterials 407 sind Pulver 411 mit einem Anteil von 40 % bis 55 % und mit einem entsprechend komplementären Anteil Klumpen 410 mit 45 % bis 60 % Gewicht enthalten. In einem dritten, oberen Drittel der Höhe 412 des Ausgangsmaterials 407 sind schließlich Siliziumcarbidpulver 411 mit einem Anteil von 25 % bis 40 % und komplementär dazu Siliziumcarbidklumpen 410 mit 60 % bis 75 % enthalten.

Das Siliziumcarbidpulver 411 weist eine Korngröße mit einem Wert aus einem Bereich von 300 µm bis 1000 µm auf. Die Siliziumcarbidklumpen 410 haben eine Korngröße mit einem Wert aus einem Bereich von 1 mm bis 5 mm. Dabei ist weiters vorgesehen, dass das Siliziumcarbid in hoher Reinheit verwendet wird. Sowohl für die Siliziumcarbidklumpen 410 als auch für das Pulver 411 ist eine Stoffreinheit von größer als 5 N vorgesehen.

Bezogen auf die gesamte Masse des zu Prozessbeginn in den Bodenbereich 406 des Tiegels 403 insgesamt gefüllten Ausgangsmaterials 407 ist ein Mischungsverhältnis von Siliziumcarbidpulver 411 und Siliziumcarbidklumpen 410 von 40 % Gewichtsanteil Siliziumcarbidpulver 411 zu 60 % Gewichtsanteil Siliziumcarbidklumpen 410 vorgesehen. Geeignet sind aber auch Mischungsverhältnisse in einem Variationsbereich von 25 % Gewichtsanteil Siliziumcarbidpulver 411 zu 75 % Gewichtsanteil Siliziumcarbidklumpen 410 bis 55 % Gewichtsanteil Siliziumcarbidpulver 411 zu 45 % Gewichtsanteil Siliziumcarbidklumpen 410.

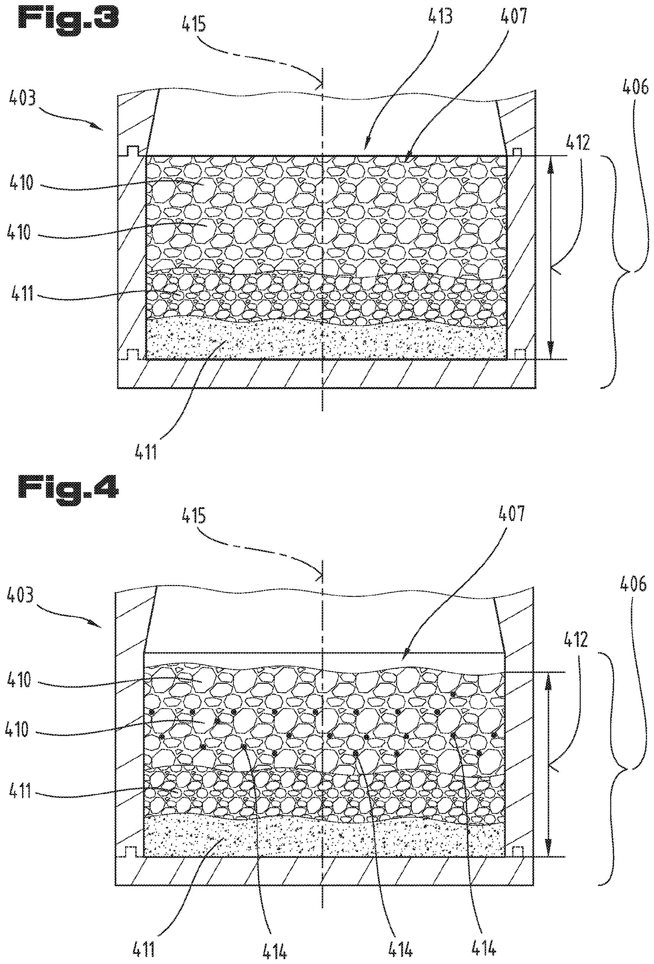

Die Fig. 3 zeigt ein zweites Ausführungsbeispiel der Vorrichtung zur Herstellung von Einkristallen gemäß Fig. 1. Dabei ist vereinfachend wiederum nur ein Detail des Tiegels 403 mit dem Bodenabschnitt 406 dargestellt. Das Ausgangsmaterial 407 der Mischung des Siliziumcarbids, das in den Bodenbereich 406 des Tiegels 403 gefüllt ist, ist in diesem Fall durch einen Pressling 413 gebildet. Das Ausgangsmaterial 407 dieses Presslings 413 besteht ebenfalls aus einer Mischung von Siliziumcarbidpulver 411 und Siliziumcarbidklumpen 410. Wie auch bei dem Ausführungsbeispiel gemäß der Fig. 2, ist eine variable Verteilung des Mischungsverhältnisses aus Klumpen 410 und Pulver 411 über den Verlauf der Höhe 412 vorgesehen. Zur Herstellung eines Presslings 413 werden die Siliziumcarbidklumpen 410 und das Siliziumcarbidpulver 411 in einem vorangehenden Fertigungsprozess zu einem kompakten Körper gepresst. Zur Herstellung des Presslings 413 kann auch eine Wärmebehandlung (ein Sinterprozess) der Siliziumcarbid-Mischung des Ausgangsmaterials 407 durchgeführt werden.

Die Fig. 4 zeigt ein drittes Ausführungsbeispiel der Vorrichtung zur Herstellung von Einkristallen gemäß Fig. 1. Dabei ist in der Mischung aus Siliziumcarbidklumpen 410 und Siliziumcarbidpulver 411 des Ausgangsmaterials 407 zusätzlich elementares Silizium 414 enthalten. Dieses Silizium 414 wird vorzugsweise in der Form von kleinkörnigem Granulat bzw. als Pulver zu dem Ausgangsmaterial 407 beigemischt und weist ebenfalls ein hohe Stoffreinheit auf. Das elementare Silizium 414 weist vorzugsweise eine Stoffreinheit von größer als 5 N auf. Durch die Beigabe des Siliziums 414 zu dem Ausgangsmaterial 407 kann ein sich über die Dauer des Kristallisationsprozesses einstellender Silizium-Mangel in der Siliziumcarbid-mischung des Ausgangsmaterials 407 ausgeglichen bzw. kompensiert werden. Das elementare Silizium 414 bildet bei diesem Ausführungsbeispiel einen Gewichtsanteil der Gesamtmasse des Ausgangsmaterials 407 mit einem Wert aus einem Bereich von 5 % bis 50 % Gewicht. Dieses wird vorzugsweise in dem zweiten, mittleren Drittel und in dem dritten, oberen Drittel der Höhe 412 des Ausgangsmaterial 407 diesem beigemischt.

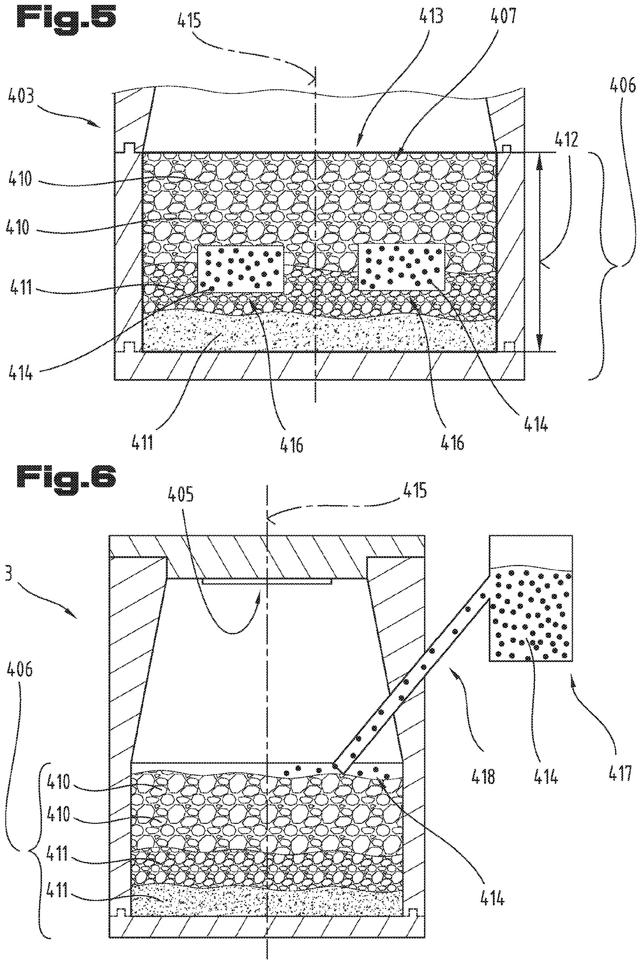

Die Fig. 5 zeigt ein viertes Ausführungsbeispiel des Ofens 401 mit dem Tiegel 403. Der Aufnahmeraum des Tiegels 403 in dessen Bodenabschnitt 406 bildet ein im Wesentlichen um eine Achse 415 rotationssymmetrisches bzw. zylinderförmiges Volumen. Das Ausgangsmaterial 407 wird außerdem durch einen Pressling 413 aus Klumpen 410 und Pulver 411 aus Siliziumcarbid gebildet. Zusätzlich sind dabei in dem Volumen des Presslings 413 Lager 416 bzw. Speicher mit elementarem Silizium 414 eingeformt bzw. eingeschlossen. Die Lager 416 in dem Pressling 413 enthalten vorzugsweise pulverförmiges Silizium 414. Die dem Pressling 413 beigegebene Menge des Siliziums 414 ist in diesem vorzugsweise in der Form eines ringförmig zusammenhängenden Lagers 416 eingeschlossen. Das Volumen des Siliziums 414 kann beispielweise in Gestalt eines Rings bzw. eines Torus in dem Pressling 413 des Ausgangsmaterials 407 eingelagert sein.

Die Fig. 6 zeigt ein weiteres, alternatives Ausführungsbeispiel der Vorrichtung zur Herstellung von Einkristallen aus Siliziumcarbid. Dabei ist in der Darstellung von dem Ofen 401 nur dessen Tiegel 403 und zusätzlich ein Vorratsbehälter 417 für pulverförmiges bzw. granulatartiges Silizium 414 gezeigt. In gleicher Weise wie bereits anhand der Fig. 2 beschrieben, wird auch bei diesem Ausführungsbeispiel das Ausgangsmaterial 407 zu Beginn durch eine Mischung aus Klumpen 410 und aus Pulver 411 des Siliziumcarbids gebildet und ist diese Mischung in dem Bodenabschnitt 406 des Tiegels 403 lose aufgeschüttet bzw. aufgeschichtet. Durch die Anordnung des Vorratsbehälters 417 mit dem elementaren Silizium 414 ist es möglich, während des Ablaufs des Kristallisationsprozesses in unterschiedlichen Phasen dem Ausgangsmaterial 407 zusätzlich zu dem Siliziumcarbid elementares Silizium 414 zuzuführen. Dazu ist zwischen dem außerhalb des Tiegels 403 angeordneten Vorratsbehälter 417 und dem Inneren des Tiegels 403 eine Zuleitung 418 vorgesehen, durch die das Silizium 414 gefördert wird. Dies kann beispielsweise mit Hilfe eines Schneckenförderers (nicht dargestellt), der das Silizium 414 der Leitung 418 zuführt bzw. durch diese fördert, erfolgen.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 401: Ofen
- 402: Kammer
- 403: Tiegel
- 404: Deckel
- 405: Keimkristall
- 406: Bodenabschnitt
- 407: Ausgangsmaterial
- 408: Heizung
- 409: Isolierung
- 410: Klumpen
- 411: Pulver
- 412: Höhe
- 413: Pressling
- 414: Silizium
- 415: Achse
- 416: Lager
- 417: Vorratsbehälter
- 418: Zuleitung

## Patentansprüche

1. Verfahren zur Herstellung von Einkristallen aus Siliziumcarbid mit einer Vorrichtung, umfassend einen Ofen (401) und eine in dem Ofen (401) aufgenommene Kammer (402) mit einem Tiegel (403), wobei ein Keimkristall (405) und ein Siliziumcarbid enthaltendes Ausgangsmaterial (407) in dem Tiegel (403) angeordnet wird, **dadurch gekennzeichnet, dass** das Ausgangsmaterial (407) eine Mischung aus Siliziumcarbidpulver (411) und Siliziumcarbidklumpen (410) enthält,
- wobei das Siliziumcarbidpulver (411) eine Korngröße mit einem Wert aus einem Bereich von 300 µm bis 1000 µm aufweist
- und die Siliziumcarbidklumpen (410) eine Korngröße mit einem Wert aus einem Bereich von 1 mm bis 10 mm aufweisen,
- und dass in einem ersten, unteren Drittel einer Höhe (412) des Ausgangsmaterials (407) Siliziumcarbidpulver (411) und Siliziumcarbidklumpen (410) in einem Mischungsverhältnis enthalten sind, das ausgewählt ist aus einem Bereich von 55 % Siliziumcarbidpulver (411) zu 45 % Siliziumcarbidklumpen (410) bis 70 % Siliziumcarbidpulver (411) zu 30 % Siliziumcarbidklumpen (410),
- und in einem zweiten, mittleren Drittel der Höhe (412) des Ausgangsmaterials (407) Siliziumcarbidpulver (411) und Siliziumcarbidklumpen (410) in einem Mischungsverhältnis enthalten sind, das ausgewählt ist aus einem Bereich von 40 % Siliziumcarbidpulver (411) zu 60 % Siliziumcarbidklumpen (410) bis 55 % Siliziumcarbidpulver (411) zu 45 % Siliziumcarbidklumpen (410),
- und in einem dritten, oberen Drittel der Höhe (412) des Ausgangsmaterials (407) Siliziumcarbidpulver (411) und Siliziumcarbidklumpen (410) in einem Mischungsverhältnis enthalten sind, das ausgewählt ist aus einem Bereich von 25 % Siliziumcarbidpulver (411) zu 75 % Siliziumcarbidklumpen (410) bis 40 % Siliziumcarbidpulver (411) zu 60 % Siliziumcarbidklumpen (410).

2. Verfahren nach Anspruch 1, **dadurch gekennzeichnet, dass** bezogen auf eine Gesamtmasse das Ausgangsmaterial (407) Siliziumcarbidpulver (411) und Siliziumcarbidklumpen (410) in einem Mischungsverhältnis enthält, das ausgewählt ist aus einem Bereich von 25 % Gewichtsanteil Siliziumcarbidpulver (411) zu 75 % Gewichtsanteil Siliziumcarbidklumpen (410) bis 55 % Gewichtsanteil Siliziumcarbidpulver (411) zu 45 % Gewichtsanteil Siliziumcarbidklumpen (410).

3. Verfahren nach Anspruch 2, **dadurch gekennzeichnet, dass** bezogen auf die Gesamtmasse das Ausgangsmaterial (407) Siliziumcarbidpulver (411) und Siliziumcarbidklumpen (410) in einem Mischungsverhältnis von 40 % Gewichtsanteil Siliziumcarbidpulver (411) zu 60 % Gewichtsanteil Siliziumcarbidklumpen (410) enthält.

4. Verfahren nach einem der vorhergehenden Ansprüche, **dadurch gekennzeichnet, dass** das Siliziumcarbid (410, 411) des Ausgangsmaterials (407) eine Stoffreinheit von größer 5N aufweist.

5. Verfahren nach einem der vorhergehenden Ansprüche, **dadurch gekennzeichnet, dass** das Ausgangsmaterial (407) in der Form eines Presslings (413) gefertigt ist.

6. Verfahren nach einem der vorhergehenden Ansprüche, **dadurch gekennzeichnet, dass** zum Ausgangsmaterial (407) zusätzlich zum Siliziumcarbid elementares Silizium (414) zugeführt wird.

7. Verfahren nach Anspruch 6, **dadurch gekennzeichnet, dass** das elementare Silizium (414) in Form von Siliziumpulver (411) enthalten ist.

8. Verfahren nach Anspruch 6 oder 7, **dadurch gekennzeichnet, dass** das elementare Silizium (414) in Form eines oder mehrerer Lager in dem Ausgangsmaterial (407) eingeformt ist.

9. Verfahren nach einem der Ansprüche 6 bis 8, **dadurch gekennzeichnet, dass** das Lager mit dem elementaren Silizium (414) zu einem zusammenhängenden Ring geformt ist.

10. Verfahren nach einem der Ansprüche 6 bis 9, **dadurch gekennzeichnet, dass** das elementare Silizium (414) einen Anteil aus einem Bereich von 5 % Gewicht bis 50 % Gewicht einer Gesamtmasse des Ausgangsmaterials (407) bildet.

11. Verfahren nach einem der Ansprüche 6 bis 10, **dadurch gekennzeichnet, dass** dafür ein Vorratsbehälter (417) für das pulverförmige, elementare Silizium (414) und eine in den Tiegel (403) führende Zuleitung (418) verwendet wird.

12. Verfahren nach einem der vorhergehenden Ansprüche, **dadurch gekennzeichnet, dass** der Tiegel (403) aus Graphit hergestellt wird.

## Claims

1. A method for producing single crystals of silicon carbide with a device comprising a furnace (401) and a chamber (402) with a crucible (403), the chamber (402) being accommodated in the furnace (401), wherein a seed crystal (405) and a base material (407) containing silicon carbide is arranged in the crucible (403), **characterized in that** the base material (407) contains a mixture of silicon carbide powder (411) and silicon carbide lumps (410),
- wherein the silicon carbide powder (411) has a grain size with a value from a range of 300 µ m to 1000 µm
- and the silicon carbide lumps (410) have a grain size with a value from a range of 1 mm to 10 mm,
- and that in a first, lower third of the height (412) of the base material (407), silicon carbide powder (411) and silicon carbide lumps (410) are contained in a mix ratio selected from a range between 55% silicon carbide powder (411) to 45% silicon carbide lumps (410) and 70% silicon carbide powder (411) to 30% silicon carbide lumps (410),
- and in a second, middle third of the height (412) of the base material (407), silicon carbide powder (411) and silicon carbide lumps (410) are contained in a mix ratio selected from a range between 40% silicon carbide powder (411) to 60% silicon carbide lumps (410) and 55% silicon carbide powder (411) to 45% silicon carbide lumps (410),
- and in a third, upper third of the height (412) of the base material (407), silicon carbide powder (411) and silicon carbide lumps (410) are contained in a mix ratio selected from a range between 25% silicon carbide powder (411) to 75% silicon carbide lumps (410) and 40% silicon carbide powder (411) to 60% silicon carbide lumps (410).

2. The method according to claim 1, **characterized in that**, based on a total mass, the base material (407) contains silicon carbide powder (411) and silicon carbide lumps (410) in a mix ratio, which is selected from a range between 25 wt.% silicon carbide powder (411) to 75 wt.% silicon carbide lumps (410) and 55 wt.% silicon carbide powder (411) to 45 wt.% silicon carbide lumps (410).

3. The method according to claim 2, **characterized in that**, based on the total mass, the base material (407) contains silicon carbide powder (411) and silicon carbide lumps (410) in a mix ratio of 40 wt.% silicon carbide powder (411) to 60 wt.% silicon carbide lumps (410).

4. The method according to one of the preceding claims, **characterized in that** the silicon carbide (410, 411) of the base material (407) has a material purity of greater than 5 N.

5. The device according to one of the preceding claims, **characterized in that** the base material (407) is produced in the form of a pellet (413).

6. The method according to one of the preceding claims, **characterized in that** elementary silicon (414) is in addition to the silicon carbide added to the base material (407).

7. The method according to claim 6, **characterized in that** the elementary silicon (414) is contained in the form of silicon powder (411).

8. The method according to claim 6 or 7, **characterized in that** the elementary silicon (414) is formed into the base material (407) in the form of one or multiple stores.

9. The method according to one of claims 6 to 8, **characterized in that** the store with the elementary silicon (414) is formed into a continuous ring.

10. The method according to one of claims 6 to 9, **characterized in that** the elementary silicon (414) constitutes a proportion from a range of 5 wt.% to 50 wt.% of a total mass of the base material (407).

11. The method according to one of claims 6 to 10, **characterized in that**, for this purpose, a storage container (417) for the powdery, elementary silicon (414) and a feed line (418) leading into the crucible (403) are used.

12. The method according to one of the preceding claims, **characterized in that** the crucible (403) is made from graphite.

## Revendications

1. Procédé de fabrication de monocristaux de carbure de silicium avec un dispositif comprenant un four (401) et une chambre (402) logée dans le four (401), avec un creuset (403), dans lequel un cristal germe (405) et un matériau de départ (407) contenant du carbure de silicium sont disposés dans le creuset (403), **caractérisé en ce que** le matériau de départ (407) contient un mélange de poudre de carbure de silicium (411) et de fragments de carbure de silicium (410),
- dans lequel la poudre de carbure de silicium (411) présente une taille de grain avec une valeur dans un intervalle de 300 µm à 1000 µm
- et les fragments de carbure de silicium (410) présentent une taille de grain avec une valeur dans un intervalle de 1 mm à 10 mm,
- et **en ce que**, dans un premier tiers inférieur d'une hauteur (412) du matériau de départ (407), la poudre de carbure de silicium (411) et les fragments de carbure de silicium (410) sont contenus dans un rapport de mélange qui est sélectionné dans un intervalle entre 55 % de poudre de carbure de silicium (411) pour 45 % de fragments de carbure de silicium (410) et 70 % de poudre de carbure de silicium (411) pour 30 % de fragments de carbure de silicium (410),
- et, dans un deuxième tiers central de la hauteur (412) du matériau de départ (407), la poudre de carbure de silicium (411) et les fragments de carbure de silicium (410) sont contenus dans un rapport de mélange qui est sélectionné dans un intervalle entre 40 % de poudre de carbure de silicium (411) pour 60 % de fragments de carbure de silicium (410) et 55 % de poudre de carbure de silicium (411) pour 45 % de fragments de carbure de silicium (410),
- et, dans un troisième tiers supérieur de la hauteur (412) du matériau de départ (407), la poudre de carbure de silicium (411) et les fragments de carbure de silicium (410) sont contenus dans un rapport de mélange qui est sélectionné dans un intervalle entre 25 % de poudre de carbure de silicium (411) pour 75 % de fragments de carbure de silicium (410) et 40 % de poudre de carbure de silicium (411) pour 60 % de fragments de carbure de silicium (410).

2. Procédé selon la revendication 1, **caractérisé en ce que**, par rapport à une masse totale, le matériau de départ (407) contient la poudre de carbure de silicium (411) et les fragments de carbure de silicium (410) dans un rapport de mélange qui est sélectionné dans un intervalle entre 25 % en poids de poudre de carbure de silicium (411) pour 75 % en poids de fragments de carbure de silicium (410) et 55 % en poids de poudre de carbure de silicium (411) pour 45 % en poids de fragments de carbure de silicium (410).

3. Procédé selon la revendication 2, **caractérisé en ce que**, par rapport à une masse totale, le matériau de départ (407) contient la poudre de carbure de silicium (411) et les fragments de carbure de silicium (410) dans un rapport de mélange de 40 % en poids de poudre de carbure de silicium (411) pour 60 % en poids de fragments de carbure de silicium (410).

4. Procédé selon l'une des revendications précédentes, **caractérisé en ce que** le carbure de silicium (410, 411) du matériau de départ (407) présente une pureté supérieure à 5N.

5. Procédé selon l'une des revendications précédentes, **caractérisé en ce que** le matériau de départ (407) est fabriqué sous la forme d'une pastille (413).

6. Procédé selon l'une des revendications précédentes, **caractérisé en ce que**, au matériau de départ (407) est ajouté, en plus du carbure de silicium, du silicium élémentaire (414).

7. Procédé selon la revendication 6, **caractérisé en ce que** le silicium élémentaire (414) est contenu sous la forme de poudre de silicium (411).

8. Procédé selon la revendication 6 ou 7, **caractérisé en ce que** le silicium élémentaire (414) est moulé sous la forme d'une ou plusieurs couches dans le matériau de départ (407).

9. Procédé selon l'une des revendications 6 à 8, **caractérisé en ce que** la couche avec le silicium élémentaire (414) présente la forme d'un anneau d'une seule pièce.

10. Procédé selon l'une des revendications 6 à 9, **caractérisé en ce que** le silicium élémentaire (414) constitue une part dans un intervalle entre 5 % en poids et 50 % en poids d'une masse totale du matériau de départ (407).

11. Procédé selon l'une des revendications 6 à 10, **caractérisé en ce que**, pour celui-ci, un réservoir (417) pour le silicium élémentaire (414) sous forme de poudre et une conduite d'alimentation (418) conduisant vers le creuset (403) sont utilisés.

12. Procédé selon l'une des revendications précédentes, **caractérisé en ce que** le creuset (403) est constitué de graphite.
